Europäisches Patentamt

**European Patent Office**

**Office européen des brevets**

Veröffentlichungsnummer: **0 274 606**
**A2**

# EUROPÄISCHE PATENTANMELDUNG

Anmeldenummer: **87116664.1**

Int. Cl.⁴ **H03L 7/00 , H04L 7/02**

Anmeldetag: **11.11.87**

Priorität: **21.11.86 DE 3639759**

Veröffentlichungstag der Anmeldung:
**20.07.88 Patentblatt 88/29**

Benannte Vertragsstaaten:
**AT BE CH DE FR GB IT LI NL SE**

Anmelder: **Siemens Aktiengesellschaft Berlin und München**
**Wittelsbacherplatz 2**
**D-8000 München 2(DE)**

Erfinder: **Zwack, Eduard, Dipl.-Ing.(FH)**
**Lochhauser Strasse 86**
**D-8039 Puchheim(DE)**

Anordnung zum Bilden einer in integrierter CMOS-Schaltungstechnik realisierten Laufzeitkette und eines Phasenvergleichsgliedes.

Eine mittels in CMOS-Technologie - n-bzw. p-Kanal-Feldeffekttransistoren und aus diesen gebildeten Invertern - aus einzelnen Laufzeitgliedern (LG) gebildete Laufzeitkette (LK) und ein Phasenvergleichsglied (PVG). das in Abhängigkeit der Phasenlage zweier an seinen Eingängen anliegender digitaler Signale mitteis seiner erzeugten Ausgangssignale in definierten Grenzen die Laufzeit der Laufzeitglieder (LG) bzw. Laufzeitkette (LK) beeinflußt, sind in einer integrierten Schaltung (SLP) realisiert. Diese integrierte Schaltung (SLP) wird beispielsweise in einem datensignalgetakteten Taktgenerator, in einer Daten-Systemtakt-Phasenausgleichsschaltung und in einer Schaltungsanordnung zur Erhöhung einer vorgegebenen Taktfrequenz eingesetzt.

## FIG 3

EP 0 274 606 A2

## Anordnung zum Bilden einer in integrierter CMOS-Schaltungstechnik realisierten Laufzeitkette und eines Phasenvergleichsgliedes

Zur Phasensynchronisierung zweier digitaler Signale - insbesondere zweier digitaler Taktsignale oder Takt-und Datensignale -kommen in der Nachrichtentechnik üblicherweise integrierte Schaltungen zum Einsatz. Diese integrierten Schaltungen weisen eine gleichspannungsgesteuerte Oszillatorstufe sowie ein Phasenvergleichsglied - wie aus der Druckschrift National Semiconductor Corporation 1984, CMOS Data Book, Kap. 1, Seite 365 bekannt -auf. Diese in CMOS-Technologie - aufgebaut aus einzelnen n-und p-Kanal-Anreicherungs-Feldeffekttransistoren und aus diesen zusammengesetzten Inverter-und Transfergliedern - realisierten integrierten Schaltkreise lassen aufgrund der extern erforderlichen Kondensator-und Widerstandsbeschaltung Oszillatorfrequenzen bzw. Takt-oder Datengeschwindigkeiten je nach verwendeter CMOS-Technologie bis zu 20 MHz zu. Neue digitale Kommunikationssysteme, wie z.B. das integrierte Kommunikationsnetz ISDN und insbesondere ringförmige lokale Kommunikationsnetze. erlauben höhere bzw. wesentlich höhere Datengeschwindigkeiten. wodurch der Einsatz dieser integrierten Bausteine nicht mehr möglich erscheint.

Der Erfindung liegt die Aufgabe zugrunde, eine Anordnung anzugeben, mit der insbesondere Oszillatoren und Phasenvergleichsglieder realisierbar sind. deren Frequenz bzw. Taktgeschwindigkeit der Grenzfrequenz-bzw. Grenztaktgeschwindigkeit der CMOS-Technologie entspricht.

Diese Aufgabe wird basierend auf den eingangs beschriebenen Komponenten der CMOS-Technologie durch die Merkmale des Anspruches 1 gelöst.

Der Vorteil der erfindungsgemäßen Anordnung liegt inbesondere darin, daß alle für die Regelung der Laufzeit eines und aller Laufzeitglieder notwendigen Schaltungskomponenten in CMOS-Technologie realisiert und somit auch in einer einzigen integrierten Schaltung implementierbar sind. Hierdurch entfallen die störenden Einflüsse, verursacht durch parasitäre Kapazitäten und lange Verbindungsleitungen. bei Verbindungen zu externen Anschlüssen. wodurch die Grenzfrequenz bzw. Grenztaktgeschwindigkeiten für CMOS-Technologien erreichbar sind. Lediglich für den Einsatz bei niedrigeren Taktfrequenzen kann - wie in Anspruch 2 definiert - ein Kondensator vom Ausgang des Phasenvergleichsgliedes gegen die negative Versorgungsspannung geschaltet werden. wodurch die Reaktionsgeschwindigkeit des Phasenvergleichsgliedes an die niedrige Taktfrequenz angepaßt wird.

Des weiteren erlaubt die in einer integrierten Schaltung implementierte Laufzeitkette aufgrund der mit externen Anschlüssen verbundenen Ein-bzw. Ausgänge der einzelnen Laufzeitglieder vielfältige Anwendungsmöglichkeiten. die zum Teil in den Unteransprüchen erläutert sind. So offenbart Anspruch 3 eine Anwendung der erfindungsgemäßen Anordnung. bei der ein Taktsignaloszillator mit einem digitalen Datensignal geschwindigkeits-und phasensynchron gesteuert wird. Die Phasenlage der Datensignale bestimmt hierbei die Phasenlage des mit Hilfe der Laufzeitkette und eines hinzugefügten Invertergliedes erzeugten Taktsignals, welches dann beispielsweise an Datensignale weiterverarbeitende Einrichtungen übermittelt wird. Die Anzahl der die Taktfrequenz bestimmenden Laufzeitglieder ist jeweils auf die aktuelle Datengeschwindigkeit abzustimmen.

Mittels einer weiteren Ausgestaltung der erfindungsgemäßen Anordnung - Anspruch 4 - kann ein Phasenausgleich zwischen in einer datenverarbeitenden Einrichtung erzeugten Taktsignalen und an diese Einrichtung übermittelten Datensignalen durchgeführt werden. Hierbei wird die aktuelle Phasenabweichung durch das Phasenvergleichsglied festgestellt und je nach Abweichung durch Abgabe unterschiedlicher Gleichspannungspegel an dessen Ausgang die Laufzeit der einzelnen Laufzeitglieder variiert. Die Phasenanpassung selbst erfolgt in einer aus mehreren Registern gebildeten und von den Ausgängen der Laufzeitglieder gesteuerten bzw. getakteten Registerkette in einer der Anzahl der Laufzeitglieder entsprechende Anzahl von Anpassungsschritten.

Des weiteren kann die erfindungsgemäße Anordnung auch dann - Anspruch 5 - eingesetzt werden, wenn innerhalb eines Taktschrittes eines Taktsignales mehrere aufeinanderfolgende, die Taktschrittimpulslänge aufweisende Taktsignale erforderlich sind. Die Anzahl der Taktimpulse ist durch die Anzahl der Laufzeitglieder bestimmt. die jedoch wiederum von der Geschwindigkeit der Taktsignale abhängt. Die Anzahl n der erforderlichen Taktsignale kann somit im wesentlichen durch die Wahl der Taktfrequenz definiert werden. Auf ein Taktsignal bezogen liegen also n um gleiche Zeitabstände versetzte Impulsflanken vor, was - bezogen auf eine Impulsflanke des Taktsignales - einer n-fachen Taktgfrequenzsteigerung entspricht. Genützt werden kann dieser Effekt beispielsweise in einer Serien-Parallel-Umsetzeinrichtung, in die ein mit n-facher Taktfrequenz ankommender serieller Bitstrom in einen n-Bit-langen Speicher mittels der verzögerten Taktimpulse eingelesen und diese Daten dann weiter parallel verarbeitet werden. Dieses bedeutet eine einfache Möglichkeit. trotz der n-fach niedrigeren Taktsignalfrequenz. schnell ankommende Daten in n parallel angeordnete Speicher einzulesen. Eine Abstimmung der Anzahl n der Laufzeitglieder auf die Taktsignalfrequenz und die Anzahl der parallel zu verarbeitenden Datenbits ist hier ebenefalls erforderlich.

Im folgenden werden Realisierungsmöglichkeiten und Ausführungsbeispiele für einige Komponenten der erfindungsgemäßen Anordnung anhand von Schaltbildern und Blockschaltbildern näher erläutert.

Dabei ziegen:

Fig. 1 das Schaltbild eines Laufzeitgliedes.

Fig. 2 das Schaltbild eines Phasenvergleichsgliedes.

Fig. 3 die Realisierung anhand eines Blockschaltbildes in einer integrierten Schaltung,

Fig. 4 einen von ankommenden Daten gesteuerten Taktgenerator. basierend auf der integrierten Schaltung,

Fig. 5 eine Takt-Daten-Phasenausgleichsschaltung. basierend auf der integrierten Schaltung.

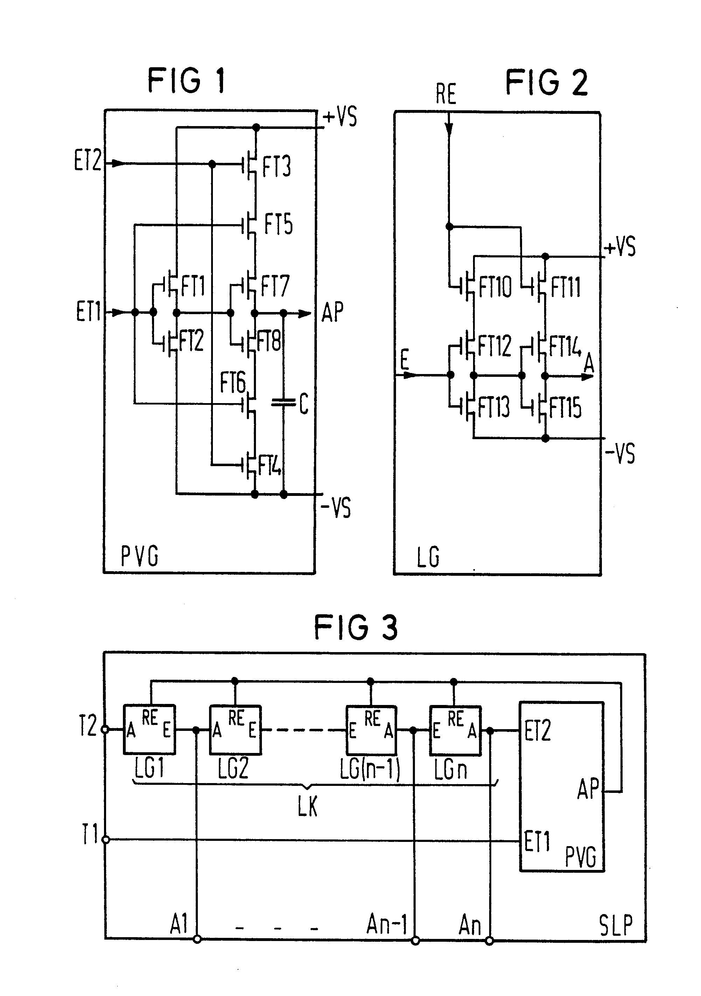

Fig. 1 zeigt das Schaltbild eines Phasenvergleichsgliedes PVG. das mittels in CMOS-Technik üblicher n-bzw. p-Kanal-Anreicherungsytp-Feldeffekttransistoren gebildet ist. Basis sowohl für dieses Phasenvergleichsglied PGV als auch für ein anschließend erläuterte Laufzeitglied LG stellt ein aus jeweils einem n-Kanal-und einem p-Kanal-Feldeffekttransistor FT gebildeter Inverter dar. Die beiden miteinander verbundenen Gate-Anschlüsse der beiden Feldeffekttransistoren FT bilden den Eingang des Inverters. Des weiteren ist der Soruce-Anschluß des p-Kanal-Feldeffekttransistors FT mit dem Drain-Anschluß des n-Kanal-Feldeffekttransistors FT verbunden und dem Ausgang des Inverters zugeordnet. Die positive Versorgungsspannung +VS gelangt über eine entsprechende Verbindung an den Drain-Anschluß des p-Kanal-Feldeffekttransistors FT und die negative Versorgungsspannung -VS wird über eine entsprechende Verbindung zum Source-Anschluß des n-Kanal-Feldeffekttransistors FT geführt. Die Schaltungsanordnung für das Phasenvergleichsglied PVG basiert auf zwei solcher in Serie geschalteter Inverter, wobei der Eingang des ersten Inverters dem Eingang ET1 des Phasenvergleichsgliedes PVG und der Ausgang des zweiten Inverters dem Ausgang AP des Phasenvergleichsgliedes PVG entspricht. Zwischen den p-Kanal-bzw. den n-Kanal-Feldeffekttransistor FT7, FT8 und der positiven Versorgungsspannung +VS bzw. der negativen Versorgungsspannung -VS sind jeweils zwei weitere p-Kanal-bzw. n-Kanal-Feldeffekttransistoren FT3. FT4. FT5. FT6 in Source-Drain-Serien-Schaltung eingefügt. Die Gate-Anschlüsse der beiden Feldeffekttransistoren FT3. FT4, an deren Drain-Anschluß die positive Versorgungsspannung +VS bzw. an deren Source-Anschluß die negative Versorgungsspannung -VS anliegt. sind mit einem zweiten Eingang ET2 des Phasenvergleichsgliedes PVG verbunden. Die Gate-Anschlüsse der den beiden Inverter-Feldeffekttransistoren FT7, FT8 folgenden Feldeffekttransistoren FT5, FT6 sind auf den ersten Eingang ET1 des Phasenvergleichsgliedes PVG geführt. Zwischen den Ausgang AP des Phasenvergleichsgliedes PVG und der negativen Versorgungsspannung -VS ist ein Kondensator C geschaltet. Ein von positiven zu negativen Spannungspegeln wechselndes und an den Eingang ET1 des Phasenvergleichsgliedes PVG geführtes Taktsignal gelangt an den Eingang des ersten Inverters und an die beiden Gate-Anschlüsse der den Feldeffekttransistoren FT7. FT8 des zweiten Inverters folgenden Feldeffekttransistoren FT4. FT5. Dieser Pegelwechsel wird im ersten Inverter FT1, FT2 um die Inverterlaufzeit verzögert und dem Eingang des zweiten Inverters FT7. FT8 zugeführt. In diesem kurzen durch die Laufzeit des ersten Inverters definierten Zeitraum. ist sowohl der p-Kanal-Feldeffekttransistor FT7 des zweiten Inverters als auch der folgende p-Kanal-Feldeffekttransistor FT5 durchgesteuert. Liegt nun am zweiten Eingang ET2 des Phasenvergleichsgliedes PVG in diesem kurzen Zeitraum ein Potential an. das den mit der positiven Versorgungsspannung +VS verbundenen p-Kanal-Feldeffekttransistor FT3 durchsteuert. so befinden sich die drei zwischen positiver Versorgungsspannung +VS und Kondensator C geschalteten p-Kanal-Feldeffekttransistoren FT3, FT5. FT7 in leitendem Zustand, wodurch der Kondensator C kurzzeitig geladen. d. h. die Spannung erhöht und anschließend gespeichert wird. Die Höhe des Ladestromes ergibt sich durch die Bahnwiderstände der drei durchgeschalteten p-Kanal-Feldeffekttransistoren FT3. FT5. FT7. Analog hierzu wird der Kondensator C kurzzeitig entladen, wenn während der Verzögerungszeit eines von negativem zu posivitem Potential wechselndes Taktsignals am Gate-Anschluß des mit der negativen Versorgungsspannung -VS verbundenen n-Kanal-Feldeffekttransistor FT4 ein entsprechendes Potential anliegt. Finden die Pegelwechsel der am ersten Eingang ET1 und am zweiten Eingang ET2 anliegenden Signale zur gleichen Zeit statt, d. h. sind sie phasensynchron, so wird innerhalb eines Taktimpulses der Kondensator C sowohl sehr kurzzeitig geladen als auch entladen. Dieses bedeutet die Beibehaltung der zuletzt im Kondensator C gespeicherten Ladung und damit das Anliegen einer annähernd gleichbleibenden Gleichspannung am Ausgang AP des Phasenvergleichsgliedes PVG.

Fig. 2 zeigt das Schaltbild eines aus mehreren Feldeffekttransistoren FT realisierten Laufzeitgliedes LG. Die Schaltungsanordnung basiert wiederum - wie bereits bei Fig. 1 erläutert -auf der Serienschaltung zweier Inverter, wobei der Eingang des ersten Inverters den Eingang E des Laufzeitgliedes LG und der Ausgang des zweiten Inverters den Ausgang A des Laufzeitgliedes LG darstellt. Zwischen dem Drain-Anschluß der p-Kanal-Feldeffekttransistoren FT12, FT14 und der positiven Versorgungsspannung +VS ist jeweils ein weiterer p-Kanal-Feldeffekttransistor FT10, FT11 eingefügt. Die beiden Gate-Anschlüsse dieser p-Kanal-Feldeffekttransistoren FT10, FT11 sind untereinander und mit einem Regeleingang RE des Laufzeigliedes LG verbunden. Die eingefügten Feldeffekttransistoren FT10, FT11 stellen regelbare Widerstände zwischen den Drain-Anschlüssen der p-Kanal-Feldeffekttransistoren FT12, FT14 und der Versorgungsspannung +VS dar. Die Regelung erfolgt durch Anlegen unterschiedlicher Gleichspannungspotentiale an den Regeleingang RE des Laufzeitgliedes LG. Aufgrund des Einfügens dieser variierbaren Widerstände kann die Laufzeit, die beispielsweise ein Taktsignal zum Durchlaufen der beiden Inverter benötigt, in durch die physikalischen Eigenschaften der beiden eingefügten Feldeffekttransistoren FT10, FT11 festgelegten Grenzen variiert werden.

Fig. 3 zeigt anhand eines Blockschaltbildes die Anordnung von Laufzeitgliedern LG sowie eines Phasenvergleichsgliedes PVG in der Art, wie sie beispielsweise in einer integrierten, in CMOS-Technologie realisierten Schaltung implementiert werden kann. Hierbei sind mehrere Laufzeitglieder LG seriell, eine Laufzeit kette LK bildend, hintereinandergeschaltet. Der Eingang der Laufzeitkette LK ist zu einem Anschlußpunkt T2, der Ausgang der Laufzeitkette LK zu dem zweiten Eingang ET2 des Phasenvergleichsgliedes PVG und zu einem Anschlußpunkt An der integrierten Schaltung SLP geführt. Die Verbindungen zwischen den Laufzeitgliedern LG sind auf die Anschlußpunkte Al...A (n-l) der integrierten Schaltung SLP geschaltet. Die Anzahl der die Laufzeitkette LK bildenden Laufzeitglieder LG hängt vom Einsatz bzw. von der Geschwindigkeit der der integrierten Schaltung SLP zugeführten Signale ab. Die integrierte Schaltung SLP ist für eine Anzahl n von Laufzeitgliedern LG konzipiert, für den aktuellen Anwendungsfall kann die Anzahl n jedoch durch entsprechende Beschaltung vermindert werden. Ein weiterer Anschlußpunkt T1 ist mit dem ersten Anschluß ET1 des Phasenvergleichsgliedes PVG verbunden. Des weiteren ist der Ausgang AP des Phasenvergleichsgliedes PVG mit allen Regeleingängen RE der Laufzeitglieder LG (l...n) verbunden. Ein am Anschluß T2 der integrierten Schaltung SLP beispielsweise anliegendes Taktsignal wird mit Hilfe des Phasenvergleichsgliedes PVG und der Laufzeitglieder LG (l...n) derart verzögert, daß dieses am zweiten Eingang ET2 des Phasenvergleichsgliedes PVG verzögert ankommende Taktsignal die gleiche Phasenlage aufweist wie ein am Anschluß T1 der integrierten Schaltung SLP und damit am ersten Eingang ET1 des Phasenvergleichsgliedes PVG anliegendes zweites Taktsignal.

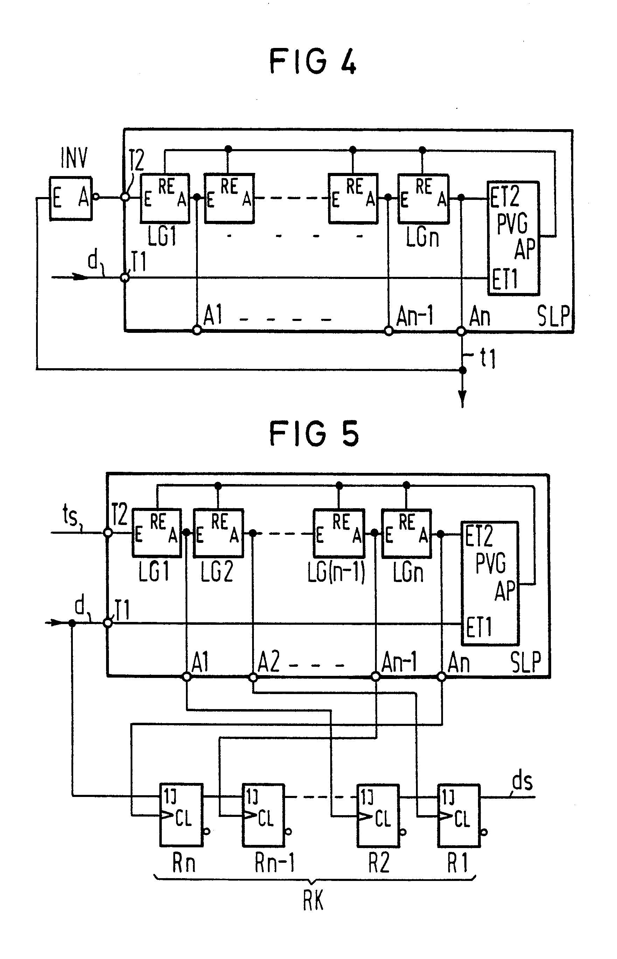

In Fig. 4 ist anhand eines Blockschaltbildes ein mittels der integrierten Schaltung SLP - entsprechend Fig. 3 - geschalteter Taktgenerator dargestellt. Der Taktgenerator wird durch Beschalten des Anschlußpunktes An - Ausgang der Laufzeitkette LK - der integrierten Schaltung SLP mit dem Eingang E eines Inverters INV und dem Verbinden des Ausgangs A dieses Inverters INV mit dem Anschlußpunkt T2 - Eingang der Laufzeitkette LK - der integrierten Schaltung SLP gebildet. Durch Einfügen des Inverters INV wird die für die Schwingungserzeugung erforderliche Phasendrehung von 180° erzielt. Die Anzahl n der in den Taktgenerator mit einbezogenen Laufzeitglieder LG bestimmen die Taktfrequenz des Taktgenerators. Die Taktfrequenz kann durch Verbinden des Ausgangs A des Inverters INV - anstelle der Verbindungen mit Anschlußpunkt T2 - mit einem der Anschlüsse Al...- (An-l) der integrierten Schaltung SLP erhöht werden. An den mit dem ersten Eingang ET1 des Phasenvergleichsgliedes PVG verbundenen Anschlußpunkt T1 der integrierten Schaltung SLP werden Datensignale d herangeführt, deren Geschwindigkeit annähernd der Taktfrequenz des implementierten Taktgenerators entspricht. Die Aufgabe der gesamten Schaltungsanordnung besteht darin, die Taktfrequenz des Taktgenerators in vorgegebenen Grenzen an die Geschwindigkeit der Datensignale d ständig anzupassen. Dies wird durch den Vergleich der Phasenlage der Datensignale d und der Taktsignale tl im Phasenvergleichsglied PVG und Verändern der Laufzeit der Laufzeitglieder LG mittels der Ausgangssignale des Phasenvergleichsglied PVG erreicht. Das Taktsignal tl weist somit eine den Datensignalen d entsprechende Geschwindigkeit und Phasenlage auf. Diese Taktsignale tl können beispielsweise als Verarbeitungs-Taktsignale an datenweiterverarbeitende Einrichtungen geführt werden.

Fig. 5 zeigt anhand eines Blockschaltbildes ein weiteres Ausführungsbeispiel der Erfindung. Durch die erfindungsgemäße Schaltungsanordnung wird das Anpassen bzw. Synchronisieren der Phasenlage von Datensignalen d an die Taktsignale ts einer diese Datensignale d weiterverarbeitenden Einrichtung erreicht. Die Schaltungsanordung basiert wiederum auf der mit den Laufzeitgliedern LG und dem Phasenvergleichsglied PVG ausgestatteten integrierten Schaltung SLP. Die in einer datenweiterverarbeitenden Einrichtung erzeugten Taktsignale ts werden an den Anschluß T2 der integrierten Schaltung SLP herangeführt. Die Datensignale d gelangen über eine entsprechende Verbindung zum Anschluß T1 der integrierten Schaltung SLP und des weiteren auf den Dateneingang 1J eines n-ten Registers Rn einer aus n-Registern bestehenden Registerkette RK. Die Anzahl Rn der seriell hintereinandergeschalteten Register R entspricht der Anzahl n der Lauftzeitglieder LG in der integrierten Schaltung SLP. Die Anschlüsse Al...An der integrierten Schaltung SLP sind jeweils mit den Takteingängen der Register Rl...Rn verbunden. Das Anpassen bzw. Synchronisieren der Phasenlage beider Signale wird mittels eines Durchtaktens des Datensignals d durch eine Registerkette RK innerhalb eines Taktsignalimpulses erreicht. wobei die Phasenlage des Datensignals d während der Übergabe von einem zum nächsten Register um den n-ten Teil der Gesamtphasenabweichung beider Signale korrigiert wird. Zu beachten ist hierbei. daß die Taktgeschwindigkeit der Datensignale d annähernd der Taktfrequenz der Taktsignale ts - d. h. in vorgegebenen Grenzen -entspricht. Mittels des Phasenvergleichsgliedes PVG und der durch dieses laufzeitgeregelten Laufzeitglieder LG wird erreicht. daß die Datensignale d am zweiten Eingang ET2 des Phasenvergleichsgliedes PVG zu den verzögerten Taktsignalen ts am ersten Eingang ET1 und damit auch die von der Registerkette RK abgegebenen Daten ds zu den Taktsignale ts phasensynchron gehalten werden. Mittels dieser Schaltungsanordnung kann ein Phasenausgleich bis zu einem I-Bit entsprechenden Taktsignal ts durchgeführt werden.

**Ansprüche**

1. Anordnung zum Bilden einer aus mehreren hintereinandergeschalteten Laufzeitgliedern (LG) gebildeten Laufzeitkette (LK) und eines nachgeschalteten Phasenvergleichsgliedes (PVG) mittels in der integrierten CMOS-Schaltungstechnik eingesetzter n-Kanal-und p-Kanal-Anreicherungs-Feldeffekttransistoren (FT) und aus diesen gebildeter Invertern. deren Eingang jeweils mit einem Gate-Anschluß eines über deren Source-Anschluß mit negativer Versorgungsspannung (-VS) verbundenen n-Kanal-Feldeffekttransistors und mit einem Gate-Anschluß eines über dessen Drain-Anschluß mit positiver Versorgungsspannung (+VS) verbundenen p-Kanal-Feldeffekttransistors verbunden ist und deren Ausgang jeweils mit dem noch nicht beschalteten Drain-bzw. Source-Anschluß des jeweiligen Feldeffekttransistors verbunden ist,

- wobei jedes Laufzeitglied (LG) teilweise durch Hintereinanderschalten zweier Inverter gebildet und im Sinne seiner Laufzeitbeeinflussung

. entweder zwischen den p-Kanal-Feldeffekttransistoren (FT12, FT14) und der positiven Versorgungsspannung (+VS) jeweils ein weiterer p-Kanal-Feldeffekttransistor (FT10. FT11) derart eingefügt wird. daß der Source-Anschluß dieses p-Kanal-Feldeffekttransistors (FT10. FT11) mit dem Drain-Anschluß des p-Kanal-Feldeffekttransistors (FT12, FT14) der Inverter die Drain-Anschlüsse mit der Versorgungsspannung (+VS) verbunden sind,

. oder zwischen die n-Kanal-Feldeffekttransistoren (FT13, FT15) und der negativen Versorgungsspannung (-VS) jeweils ein weiterer n-Kanal-Feldeffekttransistor derart eingefügt wird. daß der Drain-Anschluß dieser n-Kanal-Feldeffekttransistoren jeweils mit dem Source-Anschluß des n-Kanal-Feldeffekttransistors (FT13, FT15) der Inverter. die Source-Anschlüsse mit der negativen Versorgungsspannung (-VS) und die Gate-Anschlüsse sowohl untereinander in einem Laufzeitglied (LG) als auch mit allen Gate-Anschlüssen der jeweils anderen Laufzeitglieder (LG) verbunden sind,

- und wobei das Phasenvergleichsglied (PVG) teilweise durch zwei seriell angeordnete Inverter gebildet wird und im zweiten Inverterglied jeweils zwischen die Versorgungsspannung (+VS, -VS) und den n-bzw. p-Kanal-Feldeffekttransistoren (FT4. FT8) zwei weitere n-bzw. p-Kanal-Feldeffekttransistoren (FT3. FT5. FT4. FT6) seriell in Drain-Source-bzw. Source-Drain-Richtung eingefügt sind und die Gate-Anschlüsse der jeweils dem n-bzw. p-Kanal-Feldeffekttransistor (FT7. FT8) des zweiten Invertiergliedes folgenden Feldeffekttransistoren (FT15. FT16) auf den Eingang des Inverters zurückgeführt werden und die Gate-Anschlüsse der jeweils mit der Versorgungsspannung (+VS) verbundenen Feldeffekttransistoren (FT3, FT4) untereinander und mit dem Ausgang der Laufzeitkette (LK) verbunden sind

- und wobei zwischen den den Ausgang des Phasenvergleichsgliedes (PVG) darstellenden Ausgang (AP) des zweiten Invertergliedes und die negative Versorgungsspannung (-VS) ein Kondensator (C) einfügbar ist und der Ausgang (AP) des Phasenvergleichsgliedes (PVG) entweder direkt oder über einen weiteren Inverter mit allen untereinander verbundenen Gate-Anschlüssen der Laufzeitglieder (LG) verbunden ist,

- sowie daß die Laufzeitglieder (LG) und das Phasenvergleichsglied (PVG) in einer intergrierten Schaltung (SLP) realisiert sind und sowohl ein erster Eingang (ET1) als auch der mit dem zweiten Eingang (ET2) des Phasenvergleichsgliedes (PVG) verbundene Ausgang der Laufzeitkette (LK) sowie die Verbindungen zwischen den Gliedern der Laufzeitkette (LK) und der erste Eingang (E) des Laufzeitgliedes (LG) jeweils mit einem für eine externe Beschaltung vorgesehenen Anschluß (T1, T2, Al...An) verbunden ist.

2. Anordnung nach Anspruch 1,
**dadurch gekennzeichnet,**
daß der Ausgang (AP) des Phasenvergleichsgliedes (PVG) an einen für einen externen Anschluß eines Erweiterungskondensators vorgesehenen Ausgang der integrierten Schaltung (SLP) geführt ist.

3. Anordnung nach Anspruch 1 und 2.

**dadurch gekennzeichnet,**

daß zwischen die den Eingang (T2) und den Ausgang (An) der Laufzeitkette (LK) repräsentierenden Anschlüsse der integrierten Schaltung (SLP) im Sinne einer Taktschwingungserzeugung ein weiteres Invertierglied (INV) eingefügt ist und der erste Eingang (ET1) des Phasenvergleichsgliedes (PVG) mit einer digitale Taktsignale führenden Leitung verbunden ist und daß an dem mit dem Laufzeitkettenende verbundenen Ausgang (An) das mittels der Laufzeitkette (LK) und des Invertergliedes (INV) erzeugte und mit dem digitalen Taktsignal phasensynchron gehaltene Taktsignal anliegt.

4. Anordnung nach Anspruch 1.

**dadurch gekennzeichnet,**

daß der Eingang der Laufzeitkette (T2) mit einer digitale Taktsignale führenden Taktleitung verbunden ist und der erste Eingang des Phasenvergleichsgliedes (PVG) mit einer Datenleitung verbunden ist. über die Taktfrequenz aufweisende und mit beliebiger Phasenlage auftretende Datensignale (d) übertragen werden. daß die Datenleitung mit dem Dateneingang (1J) einer aus einer der Anzahl n der Laufzeitglieder (LG) entsprechenden Anzahl von Registern (R) gebildeten Registerkette (RK) verbunden ist. daß die Ausgänge der Laufzeitglieder (LG) jeweils mit dem Takteingang (CL) des bei mit dem das Registerkettenende darstellenden Register (R) beginnender Bezeichnung derselben von I bis n die gleiche numerische Bezeichnung aufweisenden Registers (R) verbunden sind und daß das Registerkettenende den Ausgang für die mit den Taktsignalen phasensynchrone Datensignale (ds) bildet.

5. Anordnung nach Anspruch 1.

**dadurch gekennzeichnet,**

daß eine. in definierten Bereichen in der Taktfrequenz schwankende digitale Taktsignale führende Leitung sowohl mit dem Eingang der Laufzeitkette (LK) als auch mit dem ersten Eingang (ET1) des Phasenvergleichsgliedes (PVG) verbunden ist und daß an den jeweils mit einem Ausgang eines Laufzeitgliedes (LG) verbundenen Ausgängen (Al...An) der integrierten Schaltung (SLP) jeweils um eine Laufzeit eines Laufzeitgliedes (LG) verzögerte Taktsignale im Sinne eines Weiterleitens zu einer Impulsformeinrichtung oder zu einer Einrichtung zur Erhöhung der Datenbitgeschwindigkeit bei gegebener niedriger Taktfrequenz bereitgestellt sind.

6. Anordnung nach einem der vorhergehenden Ansprüche.

**dadurch gekennzeichnet,**

daß die Anzahl n der Laufzeitglieder (LG) auf die Taktfrequenz der digitalen Taktsignale abgestimmt ist.

7. Anordnung nach einem der vorhergehenden Ansprüche.

**dadurch gekennzeichnet,**

daß die Kapazität des Kondensators (C) in Abhängigkeit von der definierten Geschwindigkeit der digitalen Taktsignale bzw. Datensignale auf die geforderte Regelgeschwindigkeit abgestimmt ist.

**BAD ORIGINAL**

0 274 606

FIG 1

FIG 2

FIG 3

# 0 274 606

# FIG 4

# FIG 5